## Europäisches Patentamt

## European Patent Office

## Office européen des brevets

(11) Veröffentlichungsnummer: **0 106 316**
**B1**

(12) # EUROPÄISCHE PATENTSCHRIFT

(45) Veröffentlichungstag der Patentschrift:
**04.01.89**

(21) Anmeldenummer: **83110190.2**

(22) Anmeldetag: **12.10.83**

(51) Int. Cl.⁴: **H 03 K 5/08,** G 06 K 9/38

(54) **Verfahren und Anordnung zur Auswertung von Amplitudenänderungen im Ausgangssignal eines optischen Sensors.**

(30) Priorität: **19.10.82 DE 3238690**

(43) Veröffentlichungstag der Anmeldung:
**25.04.84 Patentblatt 84/17**

(45) Bekanntmachung des Hinweises auf die Patenterteilung:
**04.01.89 Patentblatt 89/1**

(84) Benannte Vertragsstaaten:
**AT CH DE FR GB IT LI NL SE**

(56) Entgegenhaltungen:
**EP-A-0 070 161**
**WO-A-84/00452**
**DE-A-2 747 450**
**US-A-3 832 577**

**PATENTS ABSTRACTS OF JAPAN, Band 6, Nr. 92,**
**29. Mai 1982, Seite 970 P119 & JP - A - 57 27378**
**(RICOH K.K.) 13-02-1982**

(73) Patentinhaber: **Siemens Aktiengesellschaft Berlin und München, Wittelsbacherplatz 2, D-8000 München 2 (DE)**

(72) Erfinder: **Marguerre, Hans- Helmut, Dipl.- Phys., Mähfeldstrasse 23, D-7541 Straubenhardt 4 (DE)**

## Beschreibung

Die Erfindung bezieht sich auf ein Verfahren zur Auswertung von Amplitudenänderungen im Ausgangssignal eines optischen Sensors, insbesondere einer Fernsehkamera mit den Merkmalen des Oberbegriffs des Anspruchs 1.

Ein Verfahren zur Auswertung von Amplitudenänderungen im Ausgangssignal eines optischen Senders ist beispielsweise in "Technisches Messen", 48. Jahrgang, 1981, Heft 5, Seiten 165 bis 169, beschrieben. Hier werden die mit einer Fernsehkamera erfaßten Abbildungen eines Objekts hinsichtlich der Erkennung von Objektkanten ausgewertet. Da im Ausgangssignal der Fernsehkamera (Videosignal) alle Helligkeitsschwankungen im erfaßten Fernsehbild als Amplitudenänderungen erscheinen, ist auch die Erkennung einer Objektkante aufgrund der damit in den überwiegenden Fällen verbundenen Helligkeitsschwankungen aus dem Videosignal möglich. Die Kantenerkennung bei einem Verfahren dieser Art ist um so genauer, je weniger die Kante von einer vertikalen Lage (senkrecht zur Zeilenrichtung) im Fernsehbild abweicht. Durch eine entsprechende Drehung des Objekts oder der Kamera ist dies jedoch auf einfache Weise zu gewährleisten. Die Erkennung einer Objektkante wird beim Stand der Technik u. a. mit einem Komparatorverfahren vorgeschlagen, bei dem das Videosignal über eine Reihe hintereinandergeschalteter Widerstände in seiner Amplitude heruntergeteilt wird. Die jeweils heruntergeteilten Amplitudenwerte werden mit einer fest vorgegebenen Referenzspannung in einem zugeordneten Komparator verglichen. Die zusammengeschalteten Ausgänge der Komparatoren ermöglichen somit die Bildung eines neuen Videosignales, welches nur diskrete Werte entsprechend der Anzahl der Komparatoren annehmen kann. Durch die vorgegebene Referenzspannung sind hierbei die Schwellen festgelegt, bei denen eine Helligkeitsschwankung (Objektkante) bzw. eine Amplitudenänderung des Videosignals erfaßt wird. Bei unterschiedlichen Helligkeitsverhältnissen des zu beobachtenden Objekts bzw. bei einer durch die Optik verursachten Unschärfe der Kantenabbildung kann bei diesem bekannten Verfahren jedoch nicht ausgeschlossen werden, daß bestimmte Objektkanten nicht sicher ausgewertet werden können.

Es ist bereits aus der US-A-3 832 577 ein Verfahren der eingangs angegebenen Art bekannt, bei dem jeweils der positive und negative Spitzenwert des detektierten Signals ermittelt und zur Festlegung eines Referenzsignals herangezogen wird. Aus dem größten Amplitudenwert wird somit ein oberes Hüllkurvensignal und aus dem niedrigsten Amplitudenwert ein unteres Hüllkurvensignal erzeugt und mindestens ein zwischen dem oberen und dem unteren Hüllkurvensignal liegender Amplitudenwert als Referenzsignal gewählt.

Der Erfindung liegt die Aufgabe zugrunde, ein Verfahren zur Auswertung von Amplitudenänderungen im Ausgangssignal eines optischen Sensors zu schaffen, bei dem die Erfassung von Amplitudenänderungen auch bei unterschiedlichen optischen Abbildungs- und Beleuchtungsverhältnissen gewährleistet ist.

Zur Lösung dieser Aufgabe werden bei einem Verfahren der eingangs angegebenen Art die Merkmale des Kennzeichens des Anspruchs 1 angewendet.

Durch die Bildung von oberen und unteren Hüllkurvensignalen werden mindestens zwei Amplitudenbereiche als sogenannte Hüllflächen definiert, aus denen, abhängig von der jeweils detektierten Amplitudenänderung (Objektkante), ein optimaler Schwellwert gebildet werden kann und somit eine sichere Erkennung einer entsprechenden Amplitudenänderung gewährleistet ist. Die Bildinformation des optischen Sensors wird auf Amplitudenschwankungen um den so gebildeten Schwellwert reduziert, was zu einer Datenreduzierung bei einer nachfolgenden elektronischen Bildauswertung führt. Die Hüllflächen können jeweils aus den Maximal- und Minimalamplitudenwerten während einer Zeilenabtastung des optischen Sensors oder in Teilbereichen ermittelt werden.

Es ist hierbei möglich, das Referenzsignal aus dem arithmetischen Mittelwert des oberen und des unteren Hüllkurvensignals zu bilden, wie aus dem Stand der Technik bekannt. Die Bildung eines arithmetischen Mittelwertes läßt sich mit einfachen analogen Rechenbausteinen durchführen.

Gemäß der Erfindung wird in vorteilhafter Weise das Referenzsignal jedoch nach der Gleichung

$$U_{ref} = h_o + h_u - U_v$$

gebildet, wobei
$h_o$ das obere Hüllkurvensignal,
$h_u$ das untere Hüllkurvensignal und
$U_v$ das Ausgangssignal des optischen Sensors darstellt.

Bei dieser Ausführungsform des erfindungsgemäßen Verfahrens wird praktisch durch eine Inversion des Ausgangssignals des optischen Sensors innerhalb der beiden Hüllkurvensignale ein geeignetes Referenzsignal erzeugt, wobei sich das Referenzsignal und das Ausgangssignal des optischen Sensors (Viodeosignal $U_v$) nach Erreichen der Schaltschwelle besonders schnell voneinander entfernen. Bei einem dem Ausgangssignal des Sensors überlagerten Rauschen ist damit die Schwingneigung einer Komparatorschaltung beim anschließenden vergleich des Ausgangssignals mit dem Referenzsignal während des Schaltzeitpunktes an der Schaltschwelle besonders gering.

Um eine Untergrenze für die zu erfassenden Amplitudenänderungen des Ausgangssignals des Sensors festzulegen, wird die Differenz der Hüllkurvensignale gebildet und mit einem vorgegebenen Minimalwert verglichen, und als Ergebnis dieses Vergleichs wird ein Freigabesignal für das Binärsignal erzeugt, das aus dem Vergleich des Referenzsignals mit dem Ausgangssignal des Sensors gewonnen wird.

Das angegebene Verfahren läßt sich in vorteilhafter Weise mit einer Anordnung ausführen, bei der gemäß den Merkmalen des Oberbegriffs des Anspruchs 3 ein erster Hüllkurvenbaustein und ein zweiter Hüllkurvenbaustein zur Ermittlung der Hüllkurvensignale vorhanden ist, an deren Eingängen das Ausgangssignal (Videosignal) des optischen Sensors anliegt und deren Ausgänge jeweils auf einen Eingang eines Referenzwertbausteins geführt sind, und ein Komparator vorhanden ist, an dessen erstem Eingang das Referenzsignal am Ausgang des Referenzwertbausteins und an dessen zweitem Eingang das Ausgangssignal des Sensors anliegt und an dessen Ausgang das Binärsignal ansteht. Die Anordnung nach dieser Ausführungsform läßt sich erfindungsgemäß in einfacher Weise mit Analogbausteinen gemäß des Kennzeichens des Anspruchs 3 realisieren, wobei durch die mit den Eingangssignalen des Komparators festgelegte Schaltschwelle die Erzeugung eines Binärsignals möglich ist.

Weitere vorteilhafte Ausführungsformen der Anordnung zur Durchführung des Verfahrens sind in den Unteransprüchen 4 bis 8 angegeben.

Das erfindungsgemäße Verfahren oder die Anordnung kann in besonders vorteilhafter Weise bei einem Handhabungsautomaten zur Kantenerkennung eines zu bearbeitenden Objekts angewendet werden. Diese Erkennungsaufgaben mit optischen Sensoren in Handhabungsautomaten oder zur Fertigungssteuerung und Qualitätsprüfung von Objekten sind mit der Erfindung in besonders vorteilhafter Weise ohne die Verarbeitung allzu großer Datenmengen durchführbar.

Gute Ergebnisse lassen sich mit der Erfindung erzielen, wenn beispielsweise die Flankensteilheit der Amplitudenänderung - hervorgerufen durch Unschärfe bei Änderung des Objektabstandes, Unschärfe durch falsche Scharfeinstellung der Optik oder Unschärfe bei Verschmutzung der Optik oder fehlerhafter Beleuchtung - kritisch ist.

Auch bei einem kritischen Flankenabstand (Objektbreite bzw. Pulsbreite der Amplitudenänderung im Zeilenverlauf) - hervorgerufen durch die Objektgeometrie, die Oberflächenstrukturen oder den Abbildungsmaßstab - lassen sich mit der Anwendung der Erfindung vorteilhafte Ergebnisse erzielen.

Bei einer geringen oder unterschiedlichen Grauwertdifferenz des Objekts (Änderungsverhältnis der Amplituden) - hervorgerufen durch Objektkontrast und Beleuchtung, Sensorempfindlichkeit, Randabschattung von Optik und Sensor oder Fremdlicht des Umfeldes - ist durch die Bildung von jeweils individuell für den entsprechenden Objektteil erzeugten Hüllflächen bei der Kantenerkennung eine sichere Auswertung des Objektbildes gewährleistet.

Auch bei einem unterschiedlichen absoluten Grauwert (entsprechend der Lage der Amplitudenänderung im Schwarz-Weiß-Bereich bei einer Schwarz-Weiß-Fernsehkamera) ist durch die erfindungsgemäße Anpassung der Schaltschwelle bei der Kantenerkennung eine sichere Auswertung gewährleistet. Dieser Grauwert kann beispielsweise beeinflußt werden durch Objektkontrast und Beleuchtung, Dunkelstrom des Sensors bzw. Fremdlicht des Umfeldes.

Auch eine Ausblendung von Störsignalen ist mit der Erfindung möglich, wobei diese vor allem durch Sensor- bzw. Verstärkerrauschen, Oberflächenrauhigkeiten und Welligkeiten des Objekts oder elektrische Fremdsignale im Umfeld hervorgerufen werden können.

Die Erfindung wird anhand der Figuren erläutert, wobei Figur 1 eine aus dem Stand der Technik bekannte Schaltung, die Figuren 2, 5, 7, 9 und 10 Ausführungsbeispiele von Anordnungen oder Teilen davon zur Ausführung des Verfahrens darstellen und die Figuren 3, 4, 6 und 8 Spannungs- bzw. Impulsdiagramme zur Erläuterung der jeweils vorhergehend dargestellten Figuren zeigen.

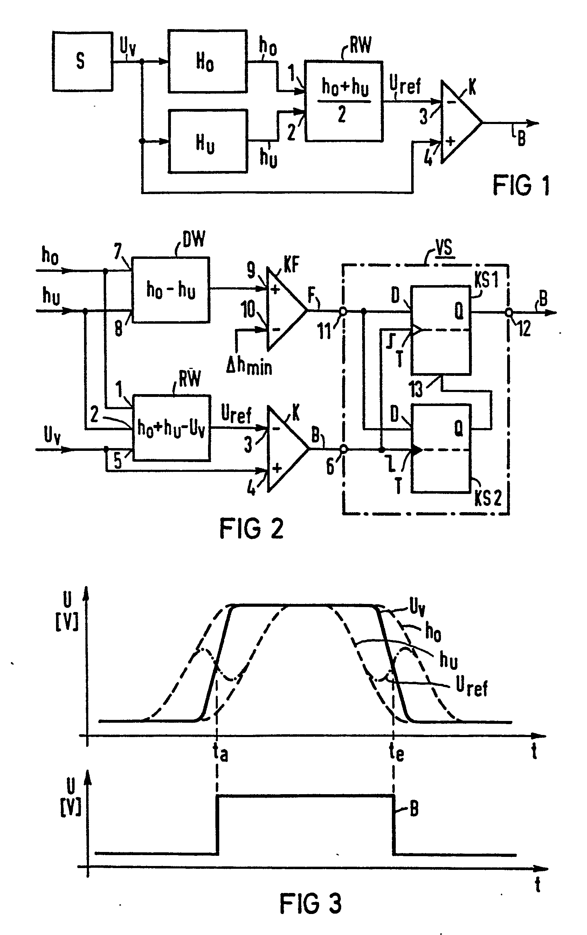

Bei der in der Figur 1 dargestellten Anordnung ist ein optischer Sensor 5 vorhanden, der ein Ausgangssignal $U_v$ als Videosignal abgibt. Das Videosignal $U_v$ ist auf den Eingang eines ersten Hüllkurvenbausteins $H_o$ und auf den Eingang eines zweiten Hüllkurvenbausteins $H_u$ geführt, Am Ausgang des ersten Hüllkurvenbausteins steht das Hüllkurvensignal $h_o$ und am Ausgang des zweiten Hüllkurvenbausteins $H_u$ das Hüllkurvensignal $h_u$ an.

Die mit diesen beiden Hüllkurvensignalen $h_o$ und $h_u$ gebildete Hüllfläche ermöglicht die Auswertung eines mit dem Sensor S erfaßten Bildes mit reduzierter Bildinformation bzw. reduzierter Auflösung. Mit diesen so definierten Hüllflächen ist auf einfache Weise eine Kantendetektion eines mit dem optischen Sensor S abgebildeten Objekts und eine Amplitudenbewertung des Videosignals $U_v$ am Ausgang des Sensors S möglich. Es kann somit eine Selektion von relevanten Daten aus der Bildinformation durchgeführt werden. Eine solche Hüllfläche kann dadurch veranschaulicht werden, indem man die Amplitude des Videosignals (entsprechend der Bildhelligkeit) als dritte Dimension über der Bildfläche des optischen Sensors definiert. Die Hüllfläche ist nur mit den höchsten Werten der Amplitude in Berührung. Amplitudenspitzen, z. B. in Nadelform, können gegebenenfalls diese Hüllfläche durchdringen, haben aber keinen Einfluß. Diese Hüllfläche läßt somit nur noch die grobe Kontur des abgebildeten Objekts bzw. der größeren Amplitudenanteile erkennen und stellt damit eine Bildinformation mit reduzierter Auflösung dar. Durch Inversion kann in gleicher Weise eine Hüllfläche für die Minimalamplituden erzeugt werden.

Das obere Hüllkurvensignal $h_o$ ist gemäß Figur 1 auf einen ersten Eingang eines Referenzwertbausteins RW geführt; das untere Hüllkurvensignal $h_u$ ist auf einen zweiten Eingang des Referenzwertbausteins RW geführt. Am Ausgang des Referenzwertbausteins RW steht ein Referenzsignal $U_{ref}$ an, das aus dem arithmetischen Mittelwert der beiden Hüllkurvensignale $h_o$, $h_u$ gebildet ist. Ein Komparator K weist einen ersten Eingang 3 auf, der mit dem Ausgang des Referenzwertbausteins RW verbunden ist, und einen zweiten Eingang 4, der mit dem Ausgang des Sensors S verbunden ist. Am Ausgang des Komparators K steht das Binärsignal B an.

Die Figur 2 enthält eine alternative Ausführungsform des Referenzwertbausteins RW, der einen dritten Eingang 5 aufweist, an dem das Videosignal $U_v$ anliegt. Am Ausgang des Referenzwertbausteins RW gemäß dieser Ausführungsform steht ein Referenzsignal $U_{ref}$ an, das nach der Beziehung

$$U_{ref} = h_o + h_u - U_v$$

gebildet ist. Der Ausgang des Referenzwertbausteins RW ist, wie bei der vorangehend beschriebenen Figur, an den Eingang 3 des Komparators K angeschaltet, an dessen zweitem Eingang 4 das Videosignal $U_v$ anliegt. Der Ausgang dieses Komparators K, an dem das Binärsignal B anliegt, ist auf einen ersten Eingang 6 einer Verknüpfungsschaltung VS geführt.

Bei dem in der Figur 2 dargestellten Ausführungsbeispiel ist weiterhin ein Differenzwertbaustein DW vorhanden, an dessen erstem Eingang 7 das obere Hüllkurvensignal $h_o$ und an dessen Eingang 8 das untere Hüllkurvensignal $h_u$ anliegt. Der Ausgang dieses Differenzwertbausteins DW, an dem die Differenz ($h_o$ - $h_u$) anliegt, ist mit einem ersten Eingang 9 eines Freigabekomparators KF angeschaltet, an dessen zweitem Eingang 10 eine vorgegebene Größe $\Delta h_{min}$ anliegt, die der vorgegebenen Mindestdifferenz der Hüllkurvensignale $h_o$ und $h_u$ entspricht. Der Ausgang des Freigabekomparators KF, an dem das Freigabesignal F anliegt, ist an einen weiteren Eingang 11 der Verknüpfungsschaltung VS angeschaltet. Am Ausgang 12 der Verknüpfungsschaltung VS steht das Binärsignal B an. Die Verknüpfungsschaltung VS enthält zwei Kippstufen KS1 und KS2, deren Takteingänge T über den ersten Eingang 6 der Verknüpfungsschaltung mit dem Binärsignal B am Ausgang des Komparators K beaufschlagt sind. Beim Takteingang T der Kippstufe KS2 handelt es sich um den negierten Eingang, beim Takteingang T der Kippstufe KS1 handelt es sich um den nicht negierten Takteingang. Die Dateneingänge D der Kippstufen KS1 und KS2 sind jeweils über den weiteren Eingang 11 der Verknüpfungsschaltung VS mit dem Freigabesignal F beaufschlagt. Der Ausgang Q der zweiten Kippstufe KS2 ist mit einem weiteren (Rücksetz-) Eingang 13 der ersten Kippstufe KS1 verbunden. Der Ausgang Q der ersten Kippstufe KS1 stellt den Ausgang der Verknüpfungsschaltung VS dar.

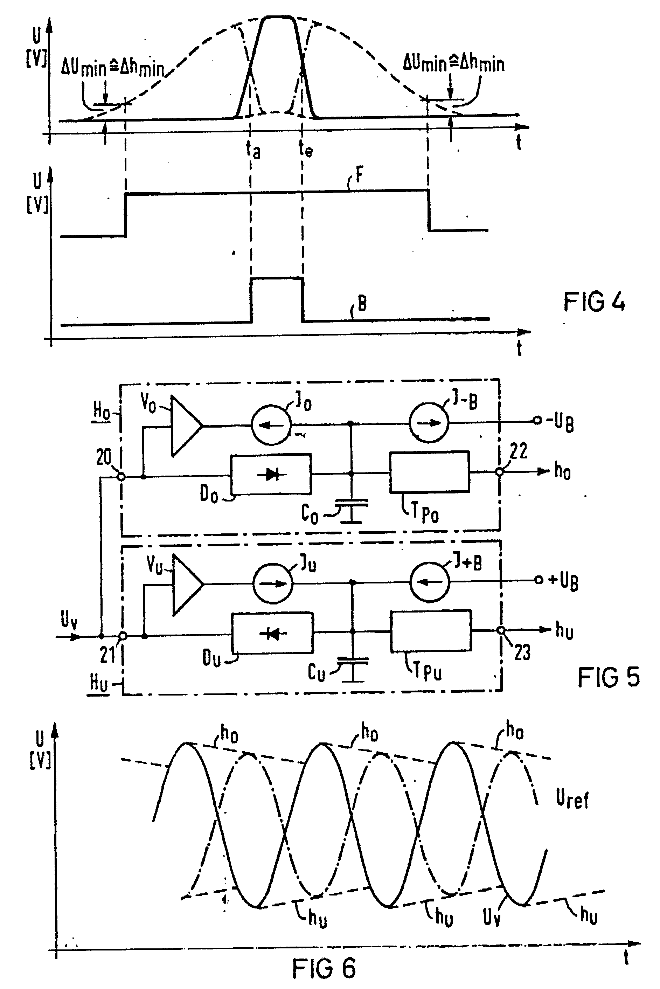

Die Funktionen der in den Figuren 1 und 2 dargestellten Anordnungen werden unter Zuhilfenahme der Diagramme in den Figuren 3 und 4 erläutert. Im oberen Diagramm der Figur 3 ist zunächst der Verlauf der Spannung U über der Zeit während der Abtastung einer Zeile im optischen Sensor S bzw. eines Teilbereichs einer Zeile dargestellt. Im Bereich des Zeitpunktes $t_a$ bei der Abtastung in einer Zeile detektiert der optische Sensor eine Kante eines Objekts, was sich durch einen Anstieg der Amplitude des Videosignals $U_v$ bemerkbar macht. Im Bereich des Zeitpunkts $t_e$ wird die andere Kante des Objekts detektiert; es erfolgt somit ein Absinken der Amplitude des Videosignals $U_v$. Durch den ersten Hüllkurvenbaustein $H_o$ wird ein oberes Hüllkurvensignal $h_o$ und durch den zweiten Hüllkurvenbaustein $H_u$ ein unteres Hüllkurvensignal $h_u$ (vergleiche Figur 1) erzeugt. Das am Ausgang des Referenzwertbausteins RW entstehende Referenzsignal $U_{ref}$ ist bei der Darstellung nach der Figur 3 nach der Beziehung

$$h_o + h_u - U_v$$

(vergleiche Figur 2) gebildet. Durch dieses Referenzsignal $U_{ref}$ ist die Schaltschwelle festgelegt, bei der, wenn das Videosignal $U_v$ den Wert des Referenzsignals $U_{ref}$ überschreitet bzw. unterschreitet (Zeitpunkte $t_a$, $t_e$), am Ausgang des Komparators K ein Binärsignal B erzeugt wird. Das Binärsignal B ist im unteren Diagramm der Figur 3 dargestellt. Gemäß der Figur 3 ist davon ausgegangen, daß das am Eingang 11 der Verknüpfungsschaltung VS (vergleiche Figur 2) anliegende Freigabesignal F gesetzt ist, d. h., Differenz $h_o$ - $h_u \geqslant \Delta h_{min}$, und daß das Binärsignal B über die Kippstufen KS2, KS1 den Ausgang 12 der Verknüpfungsschaltung VS durchschaltet. Bei der Darstellung nach der Figur 3 ist davon ausgegangen, daß die durch die Hüllkurvenbausteine $H_o$, $H_u$ festgelegten Hüllkurven ein schnelles Abklingverhalten haben.

Die Diagramme anhand der Figur 4 stellen ebenso wie die Diagramme der Figur 3 den Verlauf der Spannung, des oberen und des unteren Hüllkurvensignals sowie des Referenzsignals, des Binärsignals und außerdem des Freigabesignals dar. Bei den gemäß dieser Figur detektierten Objektkanten zu den Zeitpunkten $t_a$ und $t_e$ ist davon ausgegangen, daß die Hüllkurvensignale ein langsames Abklingverhalten haben. Außerdem ist hier die untere Schwelle $\Delta U_{min}$, die dem Signal $\Delta h_{min}$ gemäß der Figur 2 entspricht, angegeben, bei der das Freigabesignal F gesetzt bzw. zurückgesetzt wird.

In der Figur 5 sind Ausführungsbeispiele der beiden Hüllkurvenbausteine $H_o$, $H_u$ gezeigt, an deren Eingängen 20, 21 das Videosignal $U_v$ anliegt. Eingangsseitig sind bei beiden Hüllkurvenbausteinen Spitzenspannungsgleichrichter $D_o$, $D_u$ angeordnet, wobei beim Hüllkurvenbaustein $H_o$ für das obere Hüllkurvensignal $h_o$ der Spitzenspannungsgleichrichter für die positiven Spannungsspitzen in Durchlaßrichtung und beim Hüllkurvenbaustein $H_u$ für das untere Hüllkurvensignal $h_u$ der Spitzenspannungsgleichrichter $D_u$ in Sperrrichtung geschaltet ist. Die Spitzenspannungsgleichrichter $D_o$, $D_u$ dienen einer schnellen Aufladung von Glättungskondensatoren $C_o$, $C_u$, die zwischen den Ausgängen der Spitzenspannungsgleichrichter $D_o$, $D_u$ und Tiefpaßfiltern $TP_o$ und $TP_u$ angeordnet sind. Die Glättungskondensatoren $C_o$ und $C_u$ sind darüber hinaus mit den Ausgangsgrößen von Stromquellen $I_o$, $I_{-B}$ im oberen Hüllkurvenbaustein $H_o$ und $I_u$, $I_{+B}$ im unteren Hüllkurvenbaustein $H_u$ beaufschlagt. Die Stromquellen $I_o$, $I_u$ werden jeweils über Verstärker $V_o$, $V_u$ vom Videosignal $U_v$ angesteuert, die Stromquellen $I_{-B}$ und $I_{+B}$ werden jeweils von Betriebsspannungen $-U_B$ bzw. $+U_B$ versorgt. Die Polung der Stromquellen bzw. der Betriebsspannungen $-U_B$, $+U_B$ sind so gewählt, daß die Glättungskondensatoren $C_o$, $C_u$ relativ zum Videosignal $U_v$ oder zu den Betriebsspannungen $-U_B$, $+U_B$ entladen werden, wobei die Bedingung

$$-U_B < U_v < +U_B$$

gelten muß. Die in den Hüllkurvenbausteinen $H_o$, $H_u$ angeordneten Stromquellen haben die Bedeutung von Steilheitsbegrenzern für das Abklingen der Spitzenspannungen an den Ausgängen der Spitzenspannungsgleichrichter. Am Ausgang des Tiefpaßfilters $TP_o$, der mit dem Ausgang 22 des Hüllkurvenbausteins $H_o$ verbunden ist, liegt das obere Hüllkurvensignal $h_o$ an, und am Ausgang des Tiefpaßfilters $TP_u$, der gleichzeitig den Ausgang 23 des Hüllkurvenbausteins $H_u$ darstellt, liegt das untere Hüllkurvensignal $h_u$ an.

Im Diagramm nach der Figur 6 ist über der Zeit t der periodische Verlauf eines Videosignals $U_v$ dargestellt. Ferner sind die mit den anhand der Hüllkurvenbausteine nach dem in der Figur 5 dargestellten Ausführungsbeispiel erzeugten oberen Hüllkurvensignale $h_o$ und unteren Hüllkurvensignale $h_u$ eingezeichnet. Das sich daraus mit einer Schaltungsanordnung - beispielsweise gemäß der Figur 1 - ergebende Referenzsignal $U_{ref}$ schwankt daher auch somit periodisch zwischen dem oberen und dem unteren Hüllkurvensignal.

Eine symmetrische Form der Hüllkurvensignale $h_o$, $h_u$ läßt sich mit einer weiteren Ausgestaltung - hier nicht dargestellt - der Anordnung nach der Figur 5 erreichen, wenn die Bildung der Hüllkurvensignale jeweils durch eine Vorwärts- und Rückwärtsabtastung einer Zeile des mit dem optischen Sensor S erfaßten Signals und entsprechender Zwischenspeicherung erfolgt.

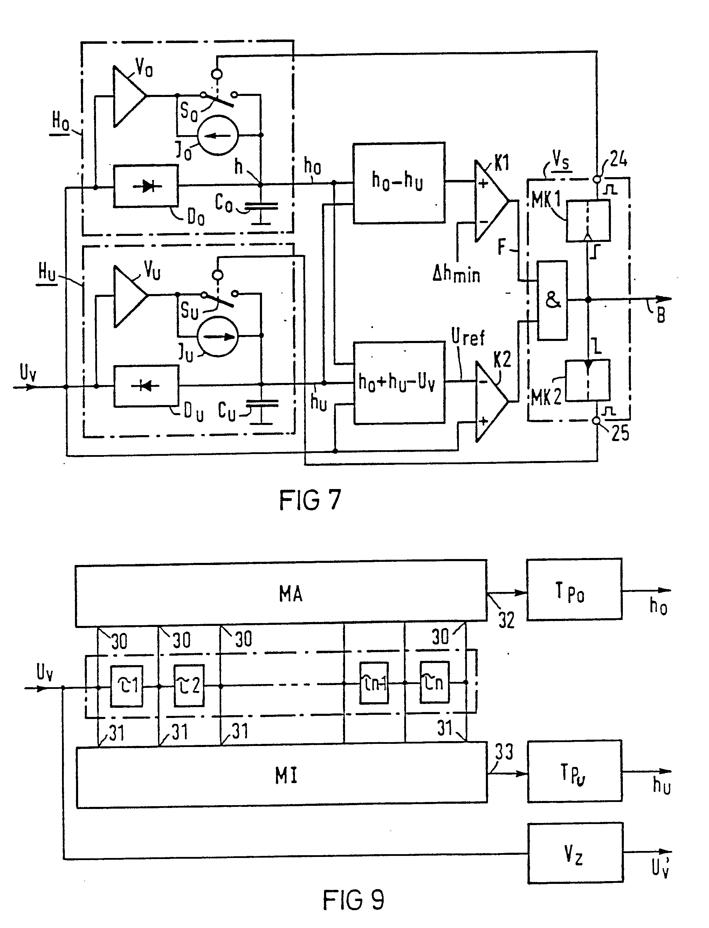

Bei dem in der Figur 7 dargestellten Ausführungsbeispiel sind Hüllkurvenbausteine $H_o$ und $H_u$ gezeigt, die im wesentlichen denen nach der Figur 5 entsprechen, jedoch ist hier auf die jeweils von der Betriebsspannung $+U_B$, $-U_B$ angesteuerte Stromquelle und auf die Tiefpaßfilter $TP_o$, $TP_u$ verzichtet worden. Statt dessen ist die Stromquelle $I_o$ mit einem Schalter $S_o$ und die Stromquelle $I_u$ mit einem Schalter $S_u$ überbrückbar. Beide Schalter $S_o$, $S_u$ sind jeweils von einem Ausgangssignal einer monostabilen Kippstufe MK1 bzw. MK2 angesteuert, die Bestandteil der Verknüpfungsschaltung VS sind. Mit den monostabilen Kippstufen MK1 und MK2 werden kurze Impulse aus den positiven bzw. negativen Flanken des Binärsignals B gebildet, wobei das Binärsignal B mit einer Schaltungsanordnung, wie sie anhand der Figur 2 beschrieben ist, erzeugt wird.

Mit den Impulsen an den Ausgängen 24 und 25 der Verknüpfungsschaltung VS wird jeweils an den Flanken des Binärsignals B ein kurzfristiges Schließen entweder des Schalters $S_o$ im oberen Hüllkurvenbaustein oder des Schalters $S_u$ im unteren Hüllkurvenbaustein ausgelöst und dadurch ein schnelles Umladen der Glättungskondensatoren $C_o$, $C_u$ auf den Pegel des jeweils aktuell anliegenden Videosignals $U_v$ erreicht. Nach beendeter Umladung öffnet der betreffende Schalter wieder. Die Hüllspannungen werden anschließend wieder aus den Spitzenspannungen des Videosignals gebildet.

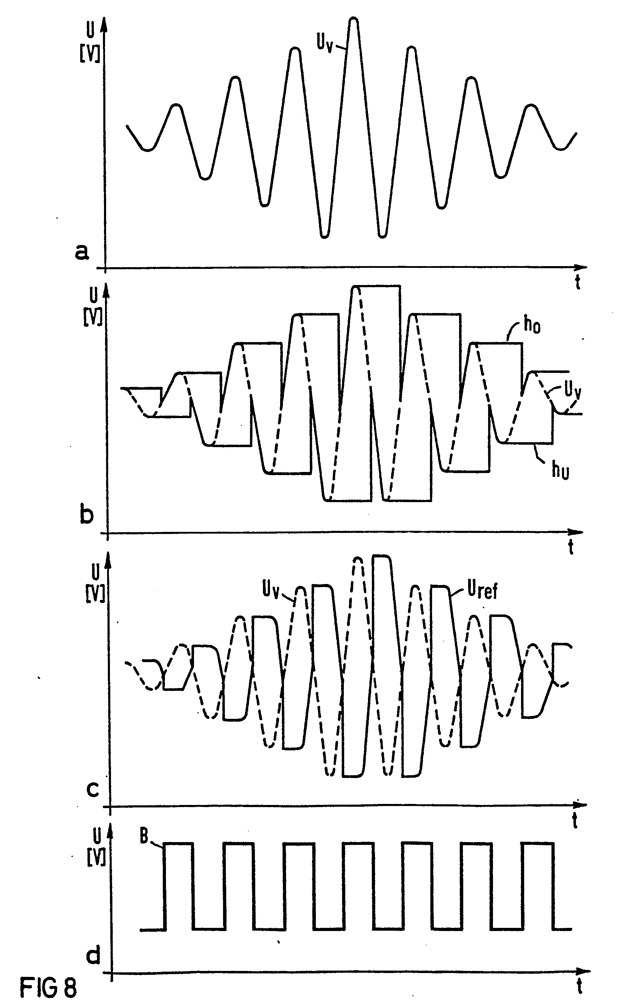

Durch die Anordnung nach diesem Ausführungsbeispiel ist erreicht, daß die Referenzspannung $U_{ref}$ sehr steile Flanken aufweist, wodurch eine geringe Anfälligkeit dieser Schaltungsanordnung gegenüber Rauschen und Störsignalen gewährleistet ist, weil sich die Referenzspannung $U_{ref}$ sehr schnell aus dem Schaltbereich in der Umgebung der Schaltschwelle des Komparators K2 entfernt. Die Funktion ist hier ähnlich der Hysterese bei sogenannten Schmitt-Triggerschaltungen. Die Spannungsverläufe in der gemäß der Figur 7 dargestellten Schaltungsanordnung sind in den Diagrammen nach der Figur 8 eingezeichnet.

Im Diagramm a) ist der angenommene Verlauf des Videosignals $U_v$ dargestellt;

im Diagramm b) sind darüber hinaus die mit den Hüllkurvenbausteinen $H_o$, $H_u$ erzeugten Hüllkurvensignale $h_o$, $h_u$ eingezeichnet.

Im Diagramm c) ist dargestellt, wie sich die Referenzspannung $U_{ref}$ in Beziehung zum Videosignal $U_v$ verhält, und

aus dem Diagramm d) der Figur 8 ist schließlich zu entnehmen, wie das Binärsignal B am Ausgang der Schaltungsanordnung mit den jeweiligen

Kreuzungspunkten des Videosignals $U_v$ und der Referenzspannung $U_{ref}$ gebildet ist.

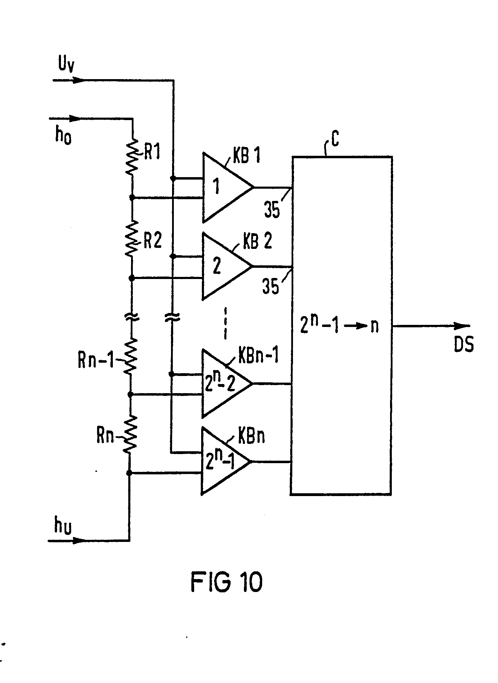

In der Figur 9 ist eine weitere Ausführungsvariante zur Erzeugung des oberen Hüllkurvensignals $h_o$ und des unteren Hüllkurvensignals $h_u$ gezeigt. Bei der Schaltungsanordnung nach dieser Ausführungsform ist eine Maximalwert-Erfassungseinheit MA und eine Minimalwert-Erfassungseinheit MI vorhanden, deren Eingänge 30 bzw. 31 mit den Ausgängen von Verzögerungsgliedern τ1 ... τn bzw. mit dem Videosignal $U_v$ verbunden sind. Mit Hilfe der Verzögerungsglieder τ1 ... τn werden jeweils um eine Zeitspanne τ verzögerte Abtastwerte des Videosignals $U_v$ innerhalb eines Teilbereichs, beispielsweise einer Fernsehzeile, erzeugt. Die Verzögerungsglieder τ1 ... τn können beispielsweise durch Ladungsverschiebeschaltungen (z. B. CCDs: Charge Coupled Device) bei analogem Eingangssignal ($U_v$) oder durch Schieberegister bei digitalem Eingangssignal ($U_v$) aufgebaut werden. Ausgänge 32 bzw. 33 der Maximalwert-Erfassungseinheit MA bzw. der Minimalwert-Erfassungseinheit MI sind mit Eingängen von Tiefpaßfiltern $TP_o$ bzw. $TP_u$ verbunden, die zur Glättung der Ausgangssignale der Einheiten MA und MI dienen; an den Ausgängen dieser Tiefpaßfilter $TP_o$ und $TP_u$ liegt das obere Hüllkurvensignal $h_o$ bzw. das untere Hüllkurvensignal $h_u$ an. Um die Verzögerungszeit der Verzögerungsglieder τ1 ... τn auszugleichen, ist das Videosignal $U_v$ ebenfalls über eine Verzögerungsschaltung VZ geführt, deren Verzögerungszeit der halben Länge der mit den Verzögerungsgliedern τ1 ... τn hervorgerufenen Verzögerungszeit entspricht. Am Ausgang der Verzögerungsschaltung VZ liegt das verzögerte Videosignal $U_v'$ an.

Es sind weitere, hier nicht dargestellte Schaltungsvarianten möglich, bei denen die Extremwerterfassung mit jeweils verzögerten Videosignalen $U_v$, beispielsweise auch mit unterschiedlichem Zeitversatz der Verzögerungsglieder τ1 ... τn, erfolgt. Es lassen sich auch mehrere solcher Extremwert-Erfassungseinheiten hintereinanderschalten, wobei sich die Verzögerungszeit, um die das Videosignal $U_v$ verzögert werden muß, ebenfalls erhöht. Es ist auch möglich, die Verzögerung durch Abtast- und Halteschaltungen vorzunehmen, die innerhalb der einzelnen Schaltungsstufen abwechselnd die Eingangssignale ($U_v$) übernehmen. Die Taktung dieser Abtast- und Halteschaltungen erfolgt mit einer von der ersten bis zur letzten Verzögerungsstufe abnehmenden Taktfrequenz.

Eine Möglichkeit zur Analog-Digital-Wandlung von Videosignalen innerhalb der von Hüllkurven bzw. Hüllflächen vorgegebenen Grenzen läßt sich mit einer Anordnung erreichen, die in der Figur 10 dargestellt ist. Die beiden Hüllkurvensignale $h_o$ und $h_u$ liegen hier an Enden einer Widerstandsreihenschaltung R1 ... Rn, deren Zwischenabgriffe jeweils auf Eingänge von Komparatoren KB1 ... KBn geführt sind. An den jeweils anderen Eingängen der Komparatoren KB1 ... KBn liegt das Videosignal $U_v$ an. Die Ausgänge der Komparatoren KB1 ... KBn sind auf Eingänge 35 eines Codierers C geschaltet, der aus den mit den Komparatoren ermittelten Vergleichsergebnissen direkt das Digitalsignal DS erzeugt. Die Analog-Digital-Wandlung oder Binärisierung von Videosignalen ist insbesondere dann von Vorteil, wenn periodische Bildinhalte vorliegen, beispielsweise bei der Spiegelung von Rasterlinien an Oberflächen mit Glanz (z. B. Lack, Chrom). Die Rasterlinien dienen dabei als Maßbezug zur Formvermessung oder zur Erkennung von Unregelmäßigkeiten (z. B. Fehler, Beschädigungen, Verschmutzungen) bei der Qualitätsprüfung von Oberflächen.

## Patentansprüche

1. Verfahren zur Auswertung von Amplitudenänderungen im Ausgangssignal eines optischen Sensors, insbesondere einer Fernsehkamera, bei dem
   - die Amplitudenwerte des Ausgangssignals Helligkeitswerten des mit dem optischen Sensor erfaßten Bildes zugeordnet sind,
   - durch Vergleich des Ausgangssignals mit einem Referenzsignal ein Binärsignal erzeugt wird,
   - aus dem größten Amplitudenwert ein oberes Hüllkurvensignal ($h_o$),
   - aus dem niedrigsten Amplitudenwert ein unteres Hüllkurvensignal ($h_u$) erzeugt wird und bei dem
   - mindestens ein zwischen dem oberen ($h_o$) und dem unteren Hüllkurvensignal ($h_u$) liegender Amplitudenwert als Referenzsignal ($U_{ref}$) gewählt wird,
   <u>dadurch gekennzeichnet</u>, daß
   - das Referenzsignal ($U_{ref}$) nach der Gleichung

$$U_{ref} = h_o + h_u - U_v$$

gebildet wird, wobei
$h_o$ das obere Hüllkurvensignal,
$h_u$ das untere Hüllkurvensignal und
$U_v$ das Ausgangssignal des optischen Sensors (S) darstellt.

2. Verfahren nach Anspruch 1, <u>dadurch gekennzeichnet</u>, daß
   - die Differenz der Hüllkurvensignale ($h_u$, $h_o$) gebildet wird und mit einem vorgegebenen Minimalwert $\Delta h_{min}$ verglichen wird und daß
   - als Ergebnis dieses Vergleichs ein Freigabesignal (F) für das Binärsignal erzeugt wird, das aus dem Vergleich des Referenzsignals ($U_{ref}$) mit dem Ausgangssignal ($U_v$) des Sensors (S) gewonnen wird.

3. Anordnung zur Durchführung des Verfahrens nach Anspruch 1 oder 2 mit
   - einem ersten Hüllkurvenbaustein ($H_o$) und

einem zweiten Hüllkurvenbaustein ($H_u$) zur Ermittlung der Hüllkurvensignale ($h_o$, $h_u$), an deren Eingängen das Ausgangssignal ($U_v$) (Videosignal) des optischen Sensors anliegt und deren Ausgänge jeweils auf einen Eingang eines Referenzwertbausteins (RW) geführt sind, und mit

- einem Komparator (K; K2), an dessen erstem Eingang das Referenzsignal ($U_{ref}$) am Ausgang des Referenzwertbausteins (RW) und an dessen zweitem Eingang das Ausgangssignal ($U_v$) des Sensors anliegt und an dessen Ausgang das Binärsignal (B) ansteht,

dadurch gekennzeichnet, daß

- mit dem Referenzwertbaustein (RW) das Referenzsignal ($U_{ref}$) nach der Gleichung

$$U_{ref} = h_o + h_u - U_v$$

gebildet wird, wobei
$h_o$ das obere Hüllkurvensignal,
$h_u$ das untere Hüllkurvensignal und
$U_v$ das Ausgangssignal des optischen Sensors (S) darstellt,

- ein Differenzwertbaustein (DW) vorhanden ist, an dessen Eingang die Hüllkurvensignale ($h_o$, $h_u$) und an dessen Ausgang die Differenz ($\Delta h$) dieser Hüllkurvensignale anliegen,

- ein Freigabekomparator (KF) vorhanden ist, an dessen erstem Eingang die Differenz ($\Delta h$) und an dessen zweitem Eingang der vorgegebene Minimalwert $\Delta h_{min}$ der Differenz ($\Delta h$) und an dessen Ausgang das Freigabesignal (F) anliegt, und daß

- eine Verknüpfungsschaltung (VS) vorhanden ist, die das Binärsignal (B) mit dem Freigabesignal (F) derart verknüpft, daß das Binärsignal (B) nur bei Vorhandensein des Freigabesignals (F) am Ausgang der Verknüpfungsschaltung (VS) ansteht.

4. Anordnung nach Anspruch 3, dadurch gekennzeichnet, daß

- jeder der beiden Hüllkurvenbausteine ($H_o$, $H_u$) eingangsseitig eine Diodenschaltung ($D_o$, $D_u$) aufweist, deren Ausgangssignal jeweils über einen Glättungskondensator ($C_o$, $C_u$) auf den Ausgang des jeweiligen Hüllkurvenbausteins ($H_o$, $H_u$) geführt ist und daß

- der Glättungskondensator ($C_o$, $C_u$) jeweils mit der Ausgangsgröße einer vom Ausgangssignal ($U_v$) des Sensors abhängigen Stromquellenschaltung ($V_o$, $I_o$; $V_u$, $I_u$) beaufschlagt ist, wobei

- die Polungen der Dioden in den Diodenschaltungen ($D_o$, $D_u$) und der ersten Stromquellen ($I_o$, $I_u$) abhängig vom jeweils zu detektierenden obersten oder untersten Amplitudenwert (oberes ($h_o$) bzw. unteres Hüllkurvensignal ($h_u$), gewählt sind.

5. Anordnung nach Anspruch 4, dadurch gekennzeichnet, daß

- der Ausgang jedes der Hüllkurvenbausteine ($H_o$, $H_u$) mit der Ausgangsgröße einer weiteren, entgegengesetzt zur ersten gepolten Stromquelle ($I_{-B}$, $I_{+B}$) beaufschlagt ist, die jeweils von einer entsprechend gepolten Betriebsspannung (-$U_B$; +$U_B$) versorgt ist.

6. Anordnung nach Anspruch 5, dadurch gekennzeichnet, daß

- die ersten Stromquellen ($I_o$; $I_u$) jeweils über einen Schalter ($S_o$, $S_u$) kurzschließbar sind, wobei der eine Schalter ($S_o$) von der positiven Flanke des Binärsignals (B) angesteuert ist.

7. Anordnung nach Anspruch 3, dadurch gekennzeichnet, daß

- die Hüllkurvenbausteine ($H_o$; $H_u$) als eine Verzögerungsschaltung aufgebaut sind, die aus einer Reihe hintereinandergeschalteter Verzögerungsglieder ($\tau 1 \ldots \tau n$) und aus je einer Minimalwert- und einer Maximalwert-Erfassungseinheit (MA; MI) besteht, wobei

- am Eingang des ersten Verzögerungsgliedes ($\tau 1$) das Ausgangssignal ($U_v$) des Sensors anliegt und die Ausgänge jedes der Verzögerungsglieder ($\tau 1 \ldots \tau n$) auf Auswerteingänge der Maximalwert- und Minimalwert-Erfassungseinheit (MA; MI) geführt sind, daß

- die Ausgänge der Maximalwert- und Minimalwert-Erfassungseinheiten (MA; MI) jeweils über Tiefpässe ($TP_o$; $TP_u$) zur Bildung des oberen ($h_o$) und des unteren Hüllkurvensignals ($h_u$) geführt sind und daß

- das Ausgangssignal ($U_v$) des Sensors über ein weiteres Verzögerungsglied (VZ) geführt ist, dessen Verzögerungzeit der halben Verzögerungzeit der Gesamtverzögerung der Verzögerungsglieder ($\tau 1 \ldots \tau n$) entspricht.

8. Anordnung nach einem der Ansprüche 3 bis 7, dadurch gekennzeichnet, daß

- der Referenzwertbaustein (RW) und der Komparator (K) als Analog-Digital-Wandlerschaltung aufgebaut sind, bei der

- das obere Hüllkurvensignal ($h_o$) und das untere Hüllkurvensignal ($h_u$) an jeweils einem Ende einer Widerstandsreihenschaltung (R1 ... Rn) angeschaltet sind, daß

- eine Anzahl n Komparatorbausteine (KB1 ... KBn) vorhanden sind, an deren jeweils ersten Eingang das Ausgangssignal ($U_v$) des Sensors und an deren jeweils zweiten Eingang die Verbindungspunkte der Widerstände der Widerstandsreihenschaltung (R1 ... Rn) angeschaltet sind und daß

- die Ausgänge der Komparatorbausteine (KB1 .. KBn) mit Eingängen eines Codierers (C) verbunden sind, an dessen Ausgang ein Digitalsignal (DS) ansteht.

## Claims

1. A process for detecting changes in amplitude of the output signal of an optical sensor, in particular a television camera, in which
- the amplitude values of the output signal are associated with brightness values of the picture received by the optical sensor,
- a binary signal is produced by comparison of the output signal with a reference signal,

- an upper envelope curve signal ($h_o$) is produced from the greatest amplitude value,
- a lower envelope curve signal ($h_u$) is produced from the lowest amplitude value, and in which
- at least one amplitude value between the upper envelope curve signal ($h_o$) and the lower envelope curve signal ($h_u$) is chosen as reference signal ($U_{ref}$)

characterised in that

- the reference signal ($U_{ref}$) is formed according to the equation

$$U_{ref} = h_o + h_u - U_v, \text{ where}$$

$h_o$ is the upper envelope curve signal
$h_u$ is the lower envelope curve signal, and
$U_v$ is the output signal from the optical sensor (S).

2. A process according to claim 1, characterised in that

- the difference between the envelope curve signals ($h_u$, $h_o$) is formed and compared with a predetermined minimum value $\Delta h_{min}$, and that
- as the result of this comparison a release signal (F) for the binary signal is produced that is obtained from the comparison of the reference signal ($U_{ref}$) with the output signal ($U_v$) of the sensor (S).

3. An arrangement for carrying out the process according to claim 1 or claim 2, having

- a first envelope curve module ($H_o$) and a second envelope curve module ($H_u$) for producing the envelope curve signals ($h_o$, $h_u$), at the inputs to which the output signal ($U_v$) (video signal) of the optical sensor are applied and their outputs being each supplied to an input of a reference value module (RW), and having,
- a comparator (K; K2) with a first input to which the reference signal ($U_{ref}$) at the output of the reference value module (RW) is applied and second input to which the output signal ($U_v$) of the sensor is supplied and an output at which the binary signal (B) is present

characterised in that

- the reference signal ($U_{ref}$) is formed by the reference value module (RW) according to the equation

$$U_{ref} = h_o + h_u - U_v, \text{ where}$$

$h_o$ is the upper envelope curve signal
$h_u$ is the lower envelope curve signal
$U_v$ is the output signal from the optical sensor (S),

- there is a differential value module (DW) having an input to which the enve lope curve signals ($h_o$, $h_u$) are supplied and an output to which the difference ($\Delta h$) of these envelope curve signals are supplied,
- there is a release comparator (KF) having a first input to which the difference ($\Delta h$) and a second input to which the predetermined minimum value $\Delta h_{min}$ of the difference ($\Delta h$) is applied and an output at which the release signal (F) is applied,

- and that there is a logic circuit (VS) that combines the binary signal (B) with the release signal (F) in such a way that the binary signal (B) is only present when the release signal (F) is applied to the input of the logic circuit (VS).

4. An arrangement according to claim 3, characterised in that

- each of the two envelope modules ($H_o$, $H_u$) has a diode circuit ($D_o$, $D_u$) of which the output signal is supplied through a smoothing capacitor ($C_o$, $C_u$) to the input of the respective envelope curve module ($H_o$, $H_u$), and that
- the smoothing capacitors ($C_o$, $C_u$) each receive the output of a respective power source circuit ($V_o$, $I_o$; $V_u$, $I_u$) dependent on the output signal ($U_v$) of the sensor, where
- the polarity of the diodes in the diode circuits ($D_o$, $D_u$) and the first power source ($I_o$, $I_u$) is selected depending on the respective one of the highest and lowest amplitude values, upper ($h_o$) or lower ($h_u$) envelope curve respectively, to be detected.

5. An arrangement according to claim 4, characterised in that

- the output of each of the envelope curve modules ($H_o$, $H_u$) receives the output of a further power source ($I_{-B}$, $I_{+B}$) of opposite polarity to the first power source that is supplied by a respective working voltage ($-U_B$; $+U_B$) of corresponding polarity.

6. An arrangement according to claim 5, characterised in that

- the first power sources ($I_o$; $I_u$) can be respectively short-circuited through a switch ($S_o$, $S_u$), one switch ($S_o$) being controlled by the positive slope of the binary signal (B).

7. An arrangement according to claim 7, characterised in that

- the envelope curve modules ($I_o$; $I_u$) are in the form of delay circuits consisting of a series of series-connected delay members ($\tau 1 \ldots \tau n$) and each comprises a minimum value and a maximum value detection unit (MA; MI), where
- at the input of the first delay member ($\tau 1$) the output signal ($U_v$) of the sensor is applied and the output of each of the delay members ($\tau 1 \ldots \tau n$) is led to external inputs of the maximum value and minimum value detecting unit (MA; MI), in that
- the outputs of the maximum value and minimum value detecting units (MA; MI) are each led through low passes ($TP_o$; $TP_u$) to form the respective upper ($h_o$) and tower ($h_u$) envelope curve signals, and in that the output signal ($U_v$) from the sensor is led through a further delay member (VZ) having a delay time half the delay time of the total delay of the delay members ($\tau 1. \ldots \tau n$).

8. An arrangement according to any one of claims 3 to 7, characterised in that

- the reference value module (RW) and the comparator (K) are in the form of analog-digital converter circuits, in which
- the upper enve lope curve signal ($h_o$) and the lower envelope curve signal ($h_u$) are connected to

respective ends of a series resistor circuit (R1 ... Rn), in that

- there are a number n of comparator modules (KB1 ... KBn) to the respective first inputs of which the output signal ($U_v$) of the sensor and to the respective second inputs of which the junctions between the resistors of the series resistor circuits (R1 ... Rn) are connected, and in that

- the outputs of the capacitor modules (KB1 ... KBn) are connected to inputs of a coder (C) at the output of which a digital signal (DS) is present.

## Revendications

1. Procédé pour l'exploitation de variations d'amplitude dans le signal de sortie d'un capteur optique, en particulier d'une caméra de télévision, procédé selon lequel

- les valeurs d'amplitude du signal de sortie sont coordonnées à des valeurs de luminosité de l'image prise par le capteur optique,

- un signal binaire est produit par la comparaison du signal de sortie avec un signal de référence,

- un signal d'enveloppe supérieur ($h_o$) est produit à partir de la valeur d'amplitude la plus grande,

- un signal d'enveloppe inférieur ($h_u$) est produit à partir de la valeur d'amplitude la plus basse, et selon lequel

- au moins une valeur d'amplitude comprise entre le signal d'enveloppe supérieur ($h_o$) et le signal d'enveloppe inférieur ($h_u$) est choisie en tant que signal de référence ($U_{ref}$),

caractérisé en ce que

- le signal de référence ($U_{ref}$) est formé selon l'équation

$$U_{ref} = h_o + h_u - U_v$$

où
$h_o$ représente le signal d'enveloppe supérieur,
$h_u$ représente le signal d'enveloppe inférieur et
$U_v$ représente le signal de sortie du capteur optique (S).

2. Procédé selon la revendication 1, caractérisé en ce que

- la différence des signaux d'enveloppe ($h_u$, $h_o$) est formée et comparée avec une valeur minimale $\Delta h_{min}$ préfixée et que

- en tant que résultat de cette comparaison, un signal d'autorisation (F) est produit pour le signal binaire, tiré de la comparaison du signal de référence ($U_{ref}$) avec le signal de sortie ($U_v$) du capteur (S).

3. Dispositif pour la mise en oeuvre du procédé selon la revendication 1 ou 2, comprenant

- un premier composant à enveloppe ($H_o$) et un second composant à enveloppe ($H_u$) pour déterminer les signaux d'enveloppe ($h_o$, $h_u$), aux entrées desquels est appliqué le signal de sortie ($U_v$) (signal vidéo) du capteur optique et dont les sorties sont reliées chacune à une entrée d'un composant à valeur de référence (RW), ainsi que

- un comparateur (K; K2) à la première entrée duquel est appliqué le signal de référence ($U_{ref}$) venant de la sortie du composant à valeur de référence (RW), à la seconde entrée duquel est appliqué le signal de sortie ($U_v$) du capteur et à la sortie duquel apparaît le signal binaire (B), caractérisé en ce que

- le signal de référence ($U_{ref}$) est produit au moyen du composant à valeur de référence (RW), selon l'équation

$$U_{ref} = h_o + h_u - U_v$$

où
$h_o$ représente le signal d'enveloppe supérieur
$h_u$ représente le signal d'enveloppe inférieur et
$U_v$ représente le signal de sortie du capteur optique (S),

- le dispositif comprend un composant à valeur différentielle (DW), à l'entrée duquel sont appliqués les signaux d'enveloppe ($h_o$, $h_u$) et sur la sortie duquel apparaît la différence ($\Delta h$) de ces signaux d'enveloppe,

- le dispositif comprend un comparateur d'autorisation (KF), à la première entrée duquel est appliquée la différence ($\Delta h$), à la seconde entrée duquel est appliquée la valeur minimale $\Delta h_{min}$ préfixée de la différence ($\Delta h$) et sur la sortie duquel apparaît le signal d'autorisation (F), et que

- le dispositif comprend un circuit logique (VS) qui combine le signal binaire (B) avec le signal d'autorisation (F), de manière que le signal binaire (B) apparaisse seulement sur la sortie du circuit logique (VS) en cas de présence du signal d'autorisation (F).

4. Dispositif selon la revendication 3, caractérisé en ce que

- chacun des deux composants à enveloppe ($H_o$, $H_u$) présente, côté entrée, un circuit à diodes ($D_o$, $D_u$) dont le signal de sortie est envoyé à travers un condensateur de lissage ($C_o$, $C_u$) à la sortie du composant à enveloppe ($H_o$, $H_u$) concerné et que

- le condensateur à lissage ($C_o$, $C_u$) reçoit la grandeur de sortie d'un circuit de sources de courant ($V_o$, $I_o$; $V_u$, $I_u$) dépendant du signal de sortie ($U_v$) du capteur,

- les polarités des diodes dans les circuits à diodes ($D_o$, $D_u$) et des premières sources de courant ($I_o$, $I_u$) étant choisies en fonction de la valeur d'amplitude la plus haute ou la plus basse à détecter à chaque fois, signal d'enveloppe supérieur ($h_o$) ou signal d'enveloppe inférieur ($h_u$).

5. Dispositif selon la revendication 4, caractérisé en ce que

- la sortie de chacun des composants à enveloppe ($H_o$, $H_u$) reçoit la grandeur de sortie d'une source de courant ($I_{-B}$, $I_{+B}$) supplémentaire, de polarité contraire à la première, qui est alimentée par une tension de service ($-U_B$; $+U_B$) polarisée en conséquence.

**EP 0 106 316 B1**

6. Dispositif selon la revendication 5, caractérisé en ce que

- les premières sources de courant ($I_o$; $I_o$) peuvent être court-circuitées chacune par un interrupteur ($S_o$, $S_u$), l'un des interrupteurs ($S_o$) étant piloté par le flanc positif du signal binaire (B).

7. Dispositif selon la revendication 3, caractérisé en ce que

- les composants à enveloppe ($H_o$; $H_u$) sont réalisés comme un circuit de retard formé d'une succession d'éléments de retard ($\tau 1 \ldots \tau n$) montés en série, ainsi que d'une unité (MA) de détection de la valeur maximale pour l'un des composants et d'une unité (MI) de détection de la valeur minimale pour l'autre composant,

- le signal de sortie ($U_v$) du capteur est appliqué à l'entrée du premier élément de retard ($\tau 1 \ldots \tau n$) et les sorties de tous les éléments de retard ($\tau 1 \ldots \tau n$) sont connectées à des entrées d'exploitation respectivement de l'unité de détection de la valeur maximale (MA) et de l'unité de détection de la valeur minimale (MI), que

- les sorties des unités de détection des valeurs maximale et minimale (MA; MI) sont connectées à travers des filtres passe-bas ($TP_o$; $TP_u$) en vue de la formation du signal d'enveloppe supérieur ($h_o$) et du signal inférieur ($h_u$) et que

- le signal de sortie ($U_v$) du capteur est envoyé à travers un élément de retard (VZ) supplémentaire dont le temps de retard correspond à la moitié du temps de retard global des éléments de retard ($\tau 1 \ldots \tau n$).

8. Dispositif selon une des revendications 3 à 7, caractérisé en ce que

- le composant à valeur de référence (RW) et le comparateur (K) sont réalisés comme un circuit convertisseur analogique-numérique, dans lequel

- le signal d'enveloppe supérieur ($h_o$) et le signal d'enveloppe inférieur ($h_u$) sont appliqués chacun à une extrémité d'un montage en série de résistances ($R1 \ldots Rn$), que le dispositif comprend

- un nombre n de composants comparateurs ($KB1 \ldots KBn$) à la première entrée de chacun desquels est appliqué le signal de sortie ($U_v$) du capteur et à la seconde entrée de chacun desquels est relié un point d'interconnexion des résistances du montage en série de résistances ($R1 \ldots Rn$) et que

- les sorties des composants comparateurs ($KB1 \ldots KBn$) sont reliées aux entrées d'un codeur (C), sur la sortie duquel apparaît un signal numérique (DS).

FIG 1

FIG 2

FIG 3

1

FIG 4

FIG 5

FIG 6

FIG 7

FIG 9

EP 0 106 316 B1

FIG 8

7

FIG 10